# EUROPEAN PATENT SPECIFICATION

(11) **EP 4 138 215 B1**
(45) Date of publication and mention of the grant of the patent: **07.10.2026**
(21) Application number: 21192279.4
(22) Date of filing: 20.08.2021
(51) Int. Cl.: H01P 5/10, H01Q 21/06, H01P 1/207, H01Q 1/02, H01Q 1/32, H01Q 1/52, H01Q 21/00

(54) **SCANNING RADAR SYSTEM WITH SUBSTRATE INTEGRATED WAVEGUIDES AND HEAT DISSIPATING STRUCTURES**
ABTASTRADARSYSTEM MIT SUBSTRATINTEGRIERTEN WELLENLEITERN UND WÄRMEABLEITENDEN STRUKTUREN
SYSTÈME DE RADAR DE BALAYAGE AVEC GUIDES D'ONDES INTÉGRÉS À SUBSTRAT ET STRUCTURES DE DISSIPATION DE CHALEUR

(43) Date of publication of application: 22.02.2023
(73) Proprietor: GM Cruise Holdings LLC, San Francisco CA 94103 (US)
(72) Inventor: MANN, Sebastian, 95521 Ottobrunn (DE); GIERE, Andre, 95521 Ottobrunn (DE); KÖRBER, Richard Johann, 95521 Ottobrunn (DE); SCHULTE, Benedikt Hubertus, 95521 Ottobrunn (DE)
(74) Representative: Manitz Finsterwald Patent- und Rechtsanwaltspartnerschaft mbB

(56) References cited:
- US-A1- 2011 140 801
- US-A1- 2012 242 427
- US-A1- 2016 218 420
- US-A1- 2017 003 377
- US-A1- 2020 321 710

## Description

### BACKGROUND

Two-dimensional scanning radar systems include several Rx and Tx antennas that are placed on a surface of a printed circuit board (PCB), where the Rx and Tx antennas are positioned relative to one another to cause the radar system to perform according to predefined specifications. As two-dimensional scanning radar systems are employed in new applications, different performance requirements for such radar systems have arisen. In an example, two-dimensional scanning radar systems are being employed in autonomous vehicles (AVs), where the AVs autonomously navigate roadways based upon outputs of the two-dimensional scanning radar systems.

As noted above, a conventional two-dimensional scanning radar system includes several Rx and Tx patch antennas, and these antennas consume a relatively large amount of space on a surface of a PCB. In addition, the conventional radar system includes several monolithic microwave integrated circuits (MMICs) that drive the Tx antennas and that process electromagnetic signals detected by the Rx antennas. These MMICs consume space on the PCB of the radar system, and additionally generate heat. Furthermore, due to mechanical designs of existing scanning radar systems, such systems may emit undesired and/or parasitic radiation into the environment, thereby negatively affecting operation of the radar systems.
US 2020/321710 A1 discloses a radar device with a first set of antennas arranged along an azimuth direction and a second set arranged along a direction having both azimuth and elevation components. The antennas in the second set are partially offset and overlapping to create a compact virtual antenna array.
US 2011/140801 A1 describes a signal converter that uses a separator section on a conductor layer to guide a high-frequency signal into a waveguide. The separator section comprises two parts that gradually spread apart to convert the signal from a normal mode to a waveguide propagation mode.
US 2012/242427 A1 discloses a high-frequency conversion circuit where a signal from a semiconductor chip is transmitted to a post-wall waveguide via a bonding wire. A path cutoff unit, formed as an opening in a ground layer below the bonding wire, facilitates the mode conversion of the signal.
US 2016/218420 A1 discloses a compact automotive radar module with a single PCB. An EMI shield with an aperture having angled sidewalls is placed over the RF components, and a radome with a matching protrusion creates a sealed, shielded cavity.

### SUMMARY

The present invention provides a two-dimensional scanning radar system and a method according to the independent claims. Embodiments are given in the subclaims, the description and the drawings.

### BRIEF DESCRIPTION OF THE DRAWINGS

Fig. 1 is an isometric view of a two-dimensional scanning radar system.
Fig. 2 is a view of a top side of a metal top layer of a printed circuit board (PCB), where the PCB is included in the radar system illustrated in Fig. 1.
Fig. 3 is an overhead semi-transparent view of a monolithic microwave integrated circuit (MMIC) mounted to the metal top layer of the PCB, where substrate integrated waveguides (SIWs) that transport electromagnetic signals to and from the MMIC are depicted.
Fig. 4 is a cutaway view of a portion of the radar system of Fig. 1.
Fig. 5 is a view of an underside of a low-profile housing that is configured to dissipate heat generated by componentry of the radar system and is further configured to suppress undesired electromagnetic emissions from componentry of the radar system.
Fig. 6 is an isometric view of the low-profile housing (mask) mounted on a topside of the PCB.
Fig. 7 is a cutaway view illustrating coupling of a radome to the low-profile housing.
Fig. 8 is a flow diagram that illustrates a methodology for transmitting an electromagnetic signal from the radar system depicted in Fig. 1.
Fig. 9 is a flow diagram that illustrates a methodology for manufacturing the radar system depicted in Fig. 1.

### DETAILED DESCRIPTION

Various technologies pertaining to a two-dimensional scanning radar system are now described with reference to the drawings, where like reference numerals are used to refer to like elements throughout. In the following description, for purposes of explanation, numerous specific details are set forth in order to provide a thorough understanding of one or more aspects. It may be evident, however, that such aspect(s) may be practiced without these specific details. In other instances, well-known structures and devices are shown in block diagram form in order to facilitate describing one or more aspects. Further, it is to be understood that functionality that is described as being carried out by certain system modules may be performed by multiple modules. Similarly, for instance, a module may be configured to perform functionality that is described as being carried out by multiple modules.

Moreover, the term "or" is intended to mean an inclusive "or" rather than an exclusive "or." That is, unless specified otherwise, or clear from the context, the phrase "X employs A or B" is intended to mean any of the natural inclusive permutations. That is, the phrase "X employs A or B" is satisfied by any of the following instances: X employs A; X employs B; or X employs both A and B. In addition, the articles "a" and "an" as used in this application and the appended claims should generally be construed to mean "one or more" unless specified otherwise or clear from the context to be directed to a singular form.

A two-dimensional scanning radar system is described herein, where the radar system includes structures that facilitate the radar system having a compact size, that further facilitate dissipation of heat generated by componentry of the radar system, and still further facilitate suppression of undesirable electromagnetic emissions from the radar system. In an aspect described in greater detail herein, some of such structures include slotted tapers and substrate integrated waveguides (SIWs), where electromagnetic signals transition directly from the slotted tapers to the SIWs without intervening microstrip lines (MSLs) therebetween. This arrangement is in contrast to conventional approaches, where electromagnetic signals transition from monolithic microwave integrated circuits (MMICs) MSLs, and then from MSLs to SIWs. Other technologies will be described in greater detail herein.

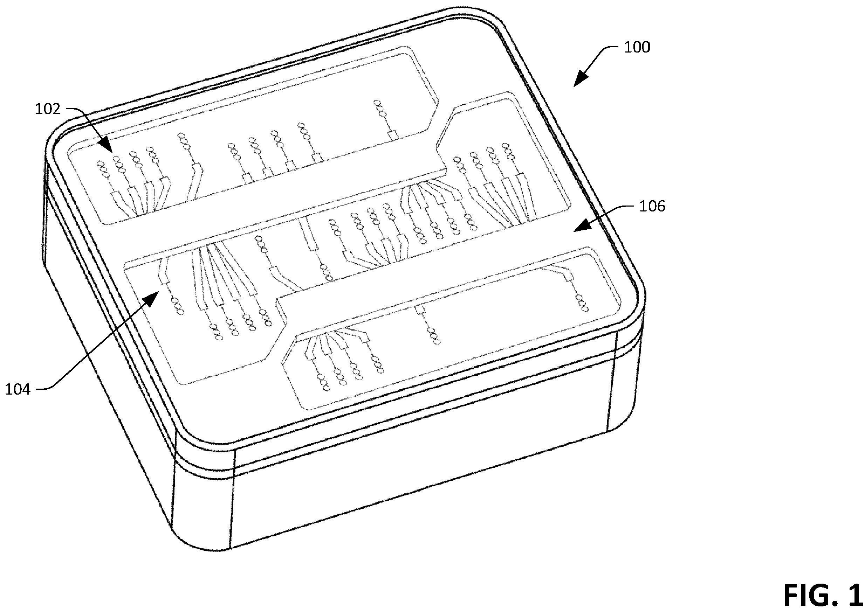

Referring now to Fig. 1, an isometric view of a two-dimensional scanning radar system 100 is illustrated. The radar system 100 includes numerous antennas that are arranged planarly and that are electromagnetically coupled to MMICs. In an example embodiment, the radar system 100 includes seven MMICs, although a radar system may include fewer or more MMICs than seven. As illustrated, each MMIC has one transmitting (Tx) antenna and four receiving (Rx) antennas electromagnetically coupled thereto. For instance, four Rx antennas 102 and one Tx antenna 104 are electromagnetically coupled to a single MMIC. Again, it is understood that an MMIC may have only Tx antennas electromagnetically coupled thereto, only Rx antennas electromagnetically coupled thereto, or different numbers of Rx and Tx antennas electromagnetically coupled thereto.

The radar system 100 includes a low-profile housing 106 that acts to dissipate heat generated by componentry of the radar system 100, and additionally acts to suppress unwanted electromagnetic emissions from MMICs that are underneath the housing 106. The housing 106 includes cutouts where the antennas are positioned, such that the housing 106 does not interfere with a field of view (FOV) of the radar system 100. In an example, the antennas are positioned in accordance with an optimized design, in order to provide desired performance of the radar system 100 (e.g., for example, a FOV of +/- 60 degrees). The housing 106 is constructed of a thermally conducting material, such as Aluminum.

The radar system 100, while not illustrated in Fig. 1, includes a printed circuit board (PCB) upon which the MMICs and antennas are mounted. The PCB includes a metal top layer (where the MMICs are mounted on the metal top layer), a substrate layer immediately beneath the metal top layer (where the antennas are mounted on the substrate layer), and a ground layer positioned beneath the substrate layer. As will be described in greater detail herein, the MMICs are electromagnetically coupled to the antennas (including the Rx antennas 102 and the Tx antenna 104) by way of electromagnetic paths that include slotted tapers and SIWs without MSLs positioned between the tapered slots and the SIWs. This arrangement, in combination with other structures on the PCB, facilitates various advantages that will be described in greater detail below, including heat dissipation, suppression of electromagnetic signals that are out-of-band, amongst others.

Due at least in part to the relatively small size of the radar system 100, the radar system 100 can be advantageously used in an automotive setting. For example, an automobile may have a computing system thereon that receives data from the radar system 100, and the computing system can cause the automobile to perform one or more driving maneuvers, such as braking, making a turn, etc. For instance, the automobile may employ output of the radar system 100 to perform one or more driver-assistance functionalities, such as initiating a braking action if an obstacle is detected, maintaining the automobile in a lane, etc. In another example, an autonomous vehicle (AV) may include the radar system 100, wherein the AV performs autonomous driving maneuvers based upon output of the radar system 100. The radar system 100 may be placed at any suitable position on the AV; in an example, the radar system 100 is mounted on a roof of the AV.

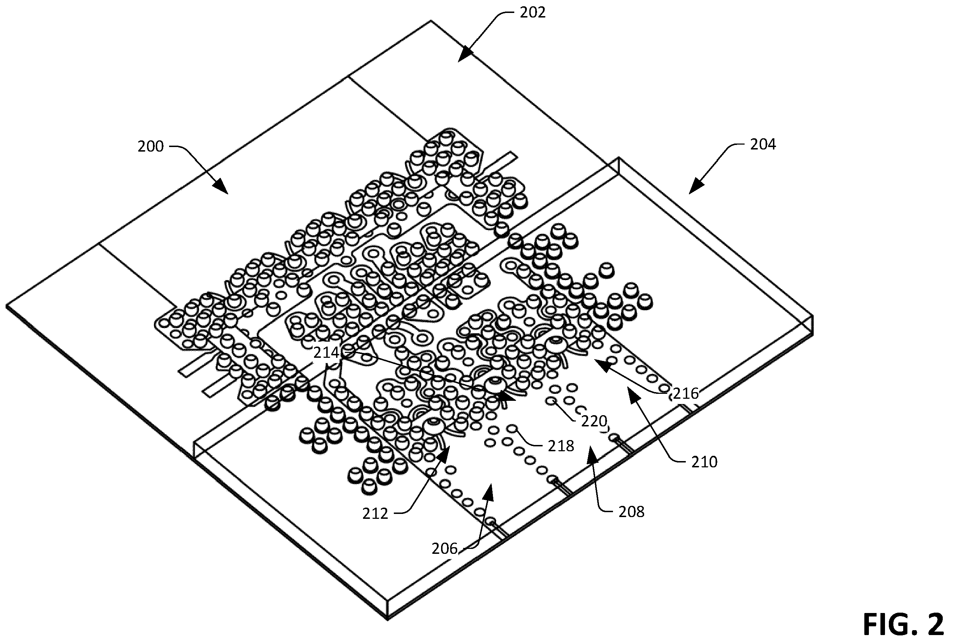

Referring now to Fig. 2, a semi-transparent isometric view of a top metal layer 200 and substrate layer 202 of a PCB 204 included in the radar system 100 is depicted. The metal layer 200 can be formed of copper and includes solder balls that are used to electrically couple MMICs to the PCB 204.

The PCB 204 includes several SIWs that are electromagnetically coupled to an MMIC that is mounted to the metal layer 200 of the PCB 204; for purposes of explanation, reference numerals 206-210 refer to three SIWs in the PCB 204. It is to be understood, however, that the PCB 204 may include more or fewer than three SIWs for each MMIC that is mounted to the PCB 204.

The PCB 204 further includes three slotted tapers 212-216, where electromagnetic radiation passes between the MMIC and the SIWs 206-210 by way of the slotted tapers 212-216, respectively. The slotted tapers 212-216 are etched into the metal layer 200 of the PCB 204. In contrast to conventional approaches in radar systems, electromagnetic radiation passes directly between the slotted tapers 212-216 and the SIWs 206-210 without intervening MSLs. This design saves a significant amount of space on the PCB 204. As illustrated in Fig. 2, each SIW is electromagnetically coupled to the MMIC by way of two slotted tapers. It is to be understood, however, that more than two slotted tapers or fewer than two slotted tapers can be employed to electromagnetically couple a MMIC to a SIW.

The SIWs also include grounded vias that are employed to match impedances of the slotted tapers with impedances of the SIWs. For instance, the SIW 208 includes grounded vias 218 and 220 that are placed within the SIW 208, wherein the grounded vias 218 and 220 are positioned relative to the slotted tapers 214, relative to walls of the SIW 208, and relative to each other such that impedance of the slotted tapers 214 matches impedance of the SIW 208 proximate the junction of the slotted tapers 214 and the SIW 208. This arrangement (e.g., the inclusion of the grounded vias 218 and 220 in the SIW 208) results in an improvement in the transmission coefficient through the transmission path that includes the slotted tapers 214 and the SIW 208 compared to the transmission coefficient when the grounded vias 218-220 are not included in the SIW 208.

The structures depicted in Fig. 2 exhibit various advantages over conventional structures employed in two-dimensional scanning radar systems. For example, the SIWs 206-210 act as high-pass filters, such that electromagnetic radiation with a frequency that falls beneath a cutoff frequency of the SIWs 206-210 does not travel through the SIWs 206-210. In an example, the cutoff frequency of the SIWs 206-210 may be 50 GHz. The grounded vias 218-220 provide additional filtering, such that electromagnetic radiation within a particular band above the cutoff frequency of the SIW 208 is able to pass between the SIW 208 and the slotted tapers 214. In an example, the frequency band is between 70 GHz and 81 GHz; electromagnetic radiation of other frequencies is filtered.

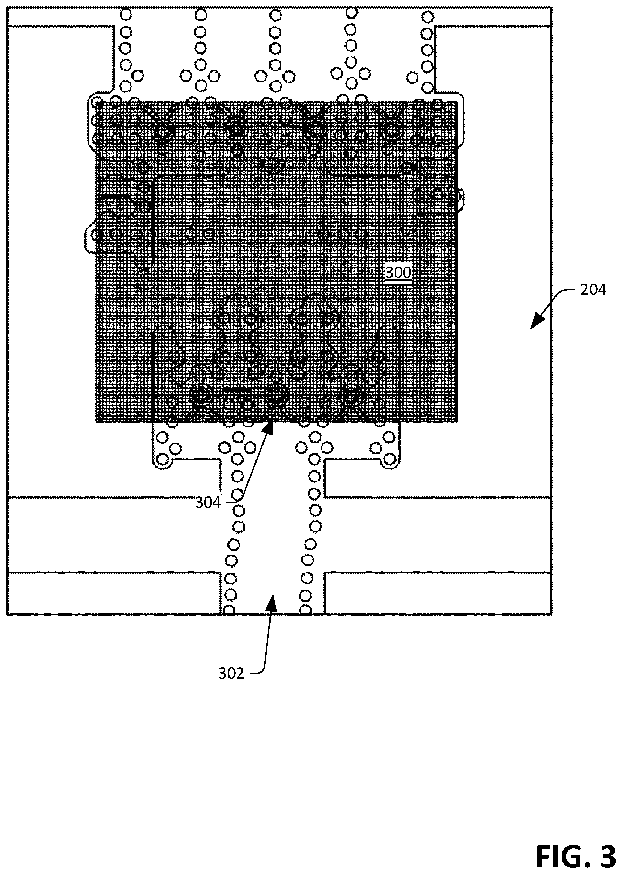

Now referring to Fig. 3, a semi-transparent overhead view of an MMIC 300 mounted on the PCB 204 is illustrated. The PCB 204 has a SIW 302 and a slotted taper 304 that is (directly) electromagnetically coupled to the SIW 302. As can be ascertained, the transition between the slotted taper 304 and the SIW 302 occurs underneath the MMIC 300, thereby saving space that in conventional designs is occupied by MSLs.

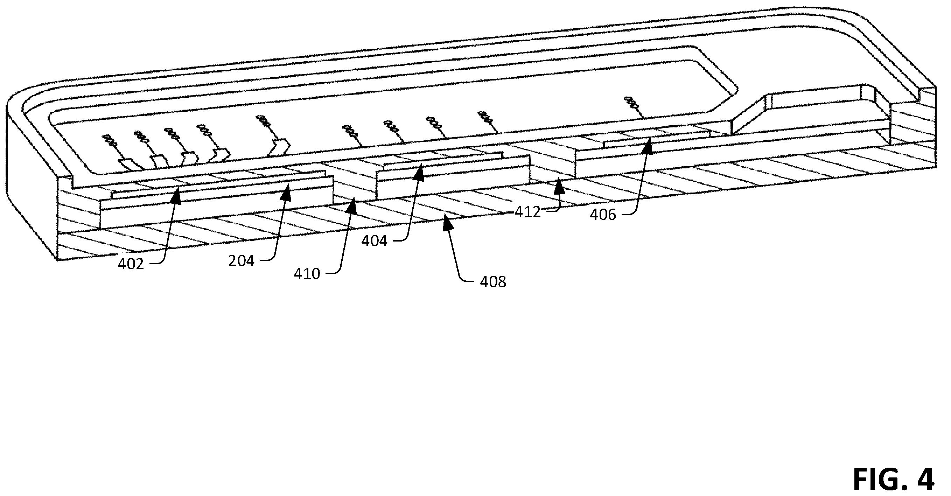

Turning now to Fig. 4, a cutaway view of a portion of the radar system 100 is illustrated. The radar system 100 includes several MMICs 402-406 that are mounted on the PCB 204. The radar system 100 further includes the housing 106, where the housing is mechanically coupled to the MMICs 402-406 by way of a heat paste (or other suitable thermally conductive material). The housing 106 covers the MMICs 402-406, but includes cutouts so that the housing 106 does not interfere with electromagnetic radiation emitted by the Tx antennas and/or electromagnetic radiation detected by the Rx antennas. Therefore, the housing 106 does not interfere with the field of view of the radar system 100.

The radar system 100 further includes a heat spreader 408 that is positioned on a backside of the PCB 204 (opposite the side of the PCB 204 where the MMICs 402-406 are mounted). The heat spreader 408 is mechanically coupled to the housing 106 by way of heat stamps 410 and 412 of the housing 106 that extend through the PCB 204. With more particularity, the PCB 204 includes cutouts between MMICs, and the heat stamps 410 and 412 are positioned in such cutouts and couple to the heat spreader 408. The heat stamps can also include mechanical fastening structures for connecting a radome to the housing 106, where the radome, when coupled to the housing 106, is at a desired distance from a top surface of the PCB 204. The mechanical fastening structures may be threaded apertures, such that the radome is coupled to the housing 106 by way of threaded fasteners (e.g., screws). In another example, the fastening structures may be dowels that extend through the heat stamps 410 and 412 and act as heat pipes. Other fastening structures are also contemplated.

The low-profile housing 106 additionally acts to suppress emission of undesired radiation from the MMICs 402-406. As illustrated in Fig. 4, the housing 106 covers the MMICs 402-406, thus suppressing electromagnetic radiation that does not enter the SIWs of the PCB 204. Accordingly, the housing 106 (in combination with the heat stamps 410 and 412) simultaneously addresses thermal issues and electromagnetic interference issues. The design of the housing 106 and heat stamps 410 and 412 is possible due to placement of the SIWs relative to the MMICs (with the slotted tapers positioned beneath the MMICs). Such topology allows for a direct, hermetically sealed attachment to the PCB 204. In addition, the radar system 100 can include electromagnetic interference foams or other electromagnetic interference countermeasures.

Still further, the radar system 100 optionally includes a signal generator that generates a local oscillator, where the signal generator is electrically coupled to each of the MMICs mounted on the PCB 204. Undesired electromagnetic emissions from interconnects between the signal generator and the MMICs can be suppressed using a variety of approaches. For instance, the local oscillator signal can be guided to an MMIC within a hermetic enclosure that encloses the MMIC. In another example, interconnects between the signal generator and one or more MMICs mounted on the PCB 204 can be placed within a substrate layer of the PCB 204. In yet another example, the signal generator can be mounted on a backside of the PCB, such that the signal generator and corresponding interconnects are entirely separated from the front surface and parasitic radiation is avoided.

During operation of the radar system 100, the MMICs 402-406 generate heat, where the heat travels from the MMIC through the thermally conductive material (such as a heat paste, sheets of thermally conductive material, etc.) to the housing 106. The heat disperses throughout the housing 106 and travels down the heat stamps 410 and 412 to the heat spreader 408. It is desirable to have equal heat distribution across all componentry (and particularly active devices such as MMICs) of the radar system 100 to guarantee comparable operation of Tx and Rx antennas of the radar system, and to further compensate for thermal nonlinear behavior (e.g., from power amplifiers, phase shifters, etc.).

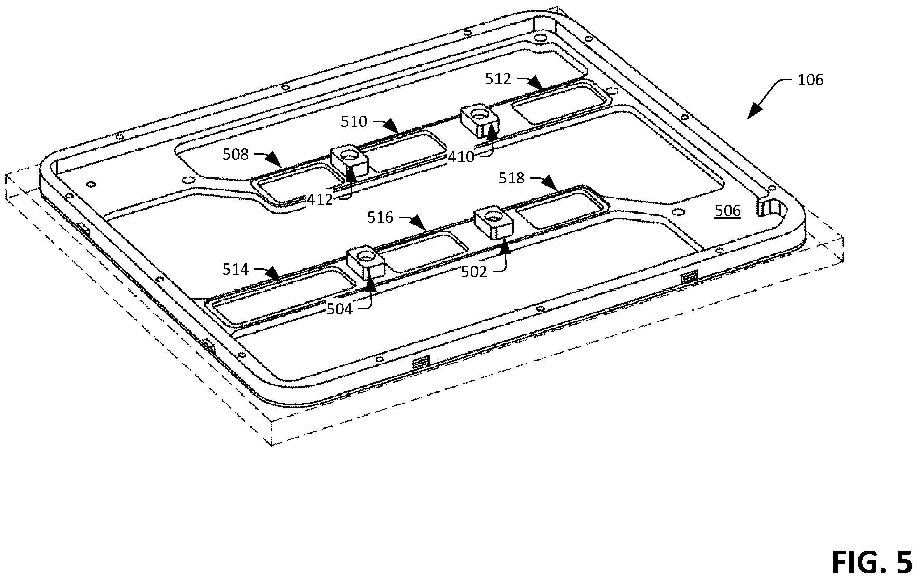

With reference now to Fig. 5, an isometric view of an underside of the low-profile housing 106 is illustrated. The housing 106 includes the heat stamps 410, 412, 502, and 504 that extend from a planar base 506 of the housing 106 away from a topside of the housing 106. The housing further includes recesses 508-518, wherein MMICs fit into the recesses when the housing 106 is set upon the PCB 204. In an example, multiple MMICs can fit into the recess 514. It is further noted that the heat stamps 410, 412, 502, and 504 are each positioned between a respective pair of recesses and are thus positioned between MMICs when the housing 106 is set upon the PCB 204.

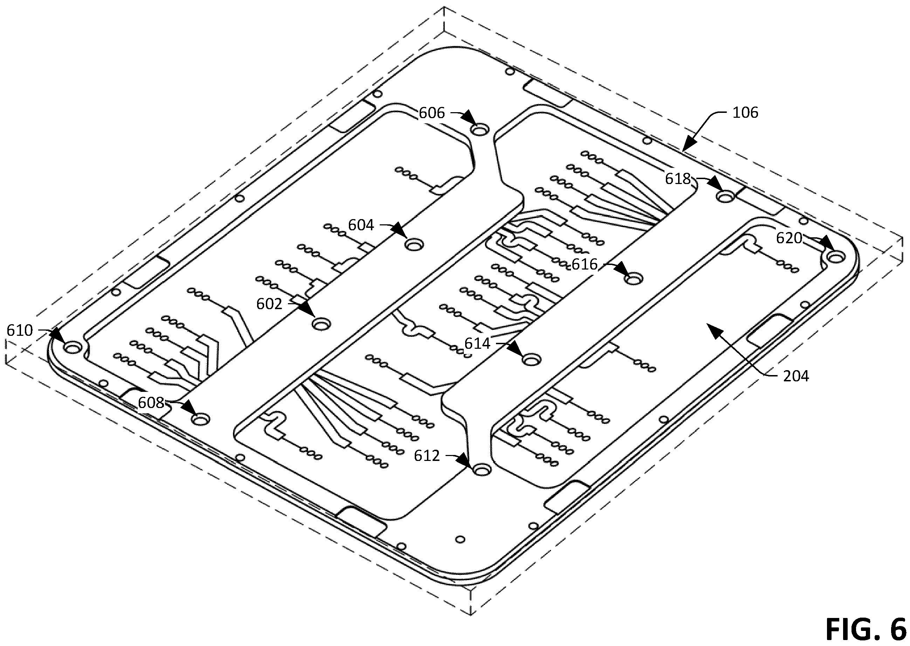

Turning now to Fig. 6, an overhead view of the housing 106 set upon the PCB 204 is depicted. The housing 106 can include apertures 602-620, where fasteners can be placed through the apertures 602-620 to secure the housing 106 to the heat spreader 408 (Fig. 4). As noted above, the fasteners may be threaded screws, dowels, and/or the like. In addition, as mentioned previously, a radome can be fastened to the housing 106 by way of the apertures 602-620 and corresponding fasteners. Fig. 6 illustrates that the housing 106 simultaneously performs functions of heat dissipation and suppression of electromagnetic interference by encapsulating MMICs mounted on the PCB 204.

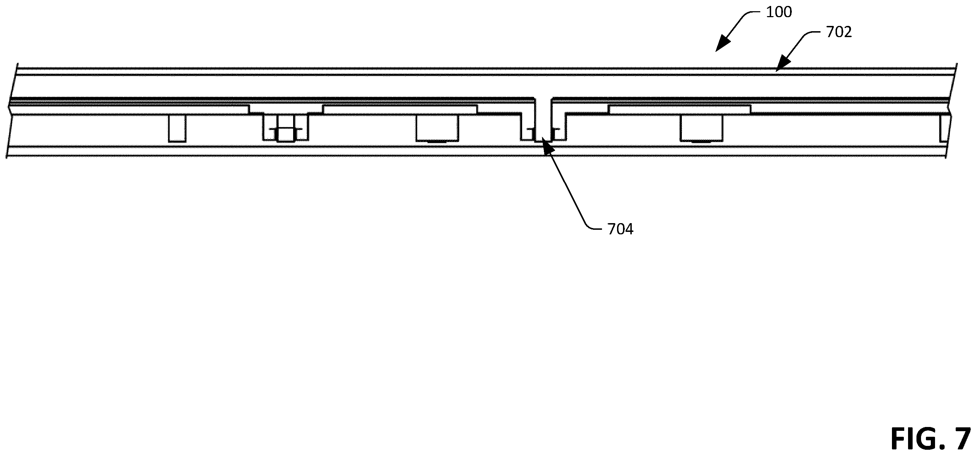

Fig. 7 is a cross-sectional view of a portion of the radar system 100, where a radome 702 is coupled to the housing 106 by way of dowels that extend through apertures of the housing 106. Heat is transferred from the housing 106 to the heat spreader 408 by way the dowels. Fig. 7 depicts a dowel 704 extending from the radome 702 through an aperture, where the aperture extends through a heat stamp of the housing 106.

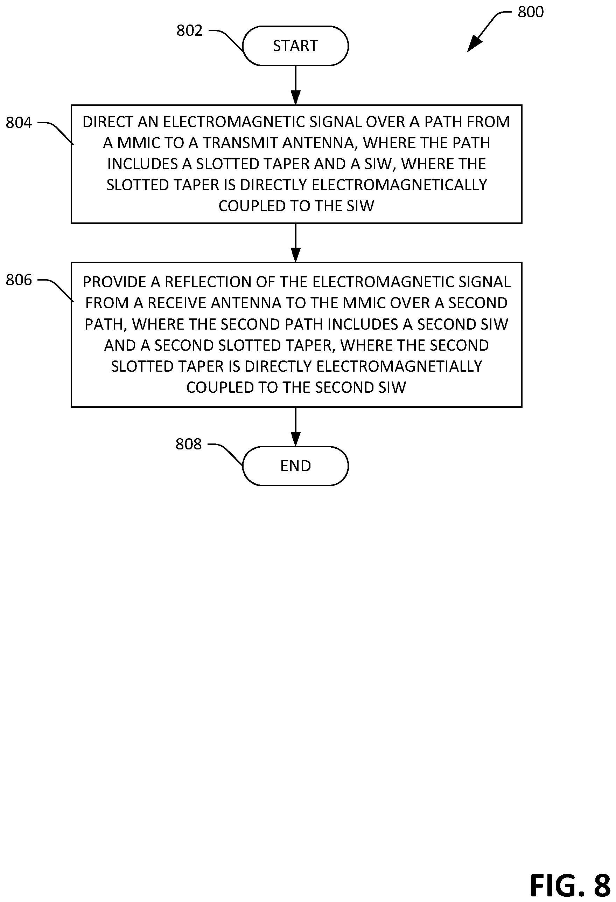

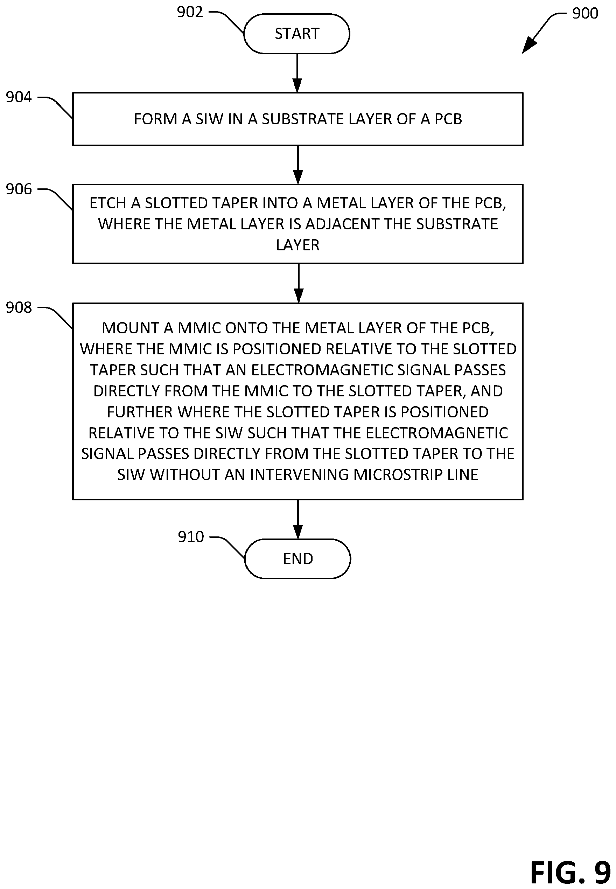

Referring to Figs. 8 and 9, methodologies pertaining to the radar system 100 are illustrated. While the methodologies are shown and described as being a series of acts that are performed in a sequence, it is to be understood and appreciated that the methodology is not limited by the order of the sequence. For example, some acts can occur in a different order than what is described herein. In addition, an act can occur concurrently with another act. Further, in some instances, not all acts may be required to implement the methodology described herein.

Moreover, some of the acts described herein may be computer-executable instructions that can be implemented by one or more processors and/or stored on a computer-readable medium or media. The computer-executable instructions can include a routine, a sub-routine, programs, a thread of execution, and/or the like. Still further, results of acts of the methodologies can be stored in a computer-readable medium, displayed on a display device, and/or the like.

Referring solely to Fig. 8, a methodology 800 performed by the radar system 100 in connection with detecting objects in a scene is illustrated. The methodology 800 starts at 802, and at 804, a Tx antenna is driven with an electromagnetic signal such that the Tx antenna radiates the electromagnetic signal into an environment of the radar system, where driving the Tx antenna with the electromagnetic signal includes directing the electromagnetic signal over a path from a MMIC to the TX antenna. The path includes a slotted taper that is etched into a metal layer of a PCB, where the MMIC is mounted to the metal layer of the PCB, and further wherein the electromagnetic signal passes from the MMIC to the slotted taper. The path additionally includes a SIW that is integrated into a substrate layer of the PCB, where the substrate layer is adjacent to the metal layer, and further wherein the electromagnetic signal passes directly from the slotted taper to the SIW without an intervening microstrip line.

At 806, a reflection of the electromagnetic signal is provided to the MMIC from an Rx antenna. The reflection travels a path from the Rx antenna to the MMIC, where the path includes a second SIW and a second slotted taper, where the reflection travels directly from the second SIW to the second slotted taper without an intervening microstrip line. The reflection passes from the slotted taper to the MMIC. An object in the scene can be detected based upon the reflection received by the MMIC. The methodology 800 completes at 808.

Now referring to Fig. 9, a methodology 900 for producing the radar system 100 is illustrated. The methodology 900 starts at 902, and at 904 an SIW is formed in a substrate layer of a PCB. At 906, a slotted taper is etched into a metal layer of the PCB, where the metal layer is adjacent the substrate layer in the PCB. At 908, a MMIC is mounted onto the metal layer of the PCB, where the MMIC is positioned relative to the slotted taper such that an electromagnetic signal generated by the MMIC passes directly from the MMIC to the slotted taper, and further where the MMIC is positioned relative to the SIW such that the electromagnetic signal passes directly from the slotted taper to the SIW without an intervening microstrip line. The methodology 900 completes at 910.

What has been described above includes examples of one or more embodiments. It is, of course, not possible to describe every conceivable modification and alteration of the above devices or methodologies for purposes of describing the aforementioned aspects, but one of ordinary skill in the art can recognize that many further modifications and permutations of various aspects are possible. Accordingly, the described aspects are intended to embrace all such alterations, modifications, and variations that fall within the scope of the appended claims. Furthermore, to the extent that the term "includes" is used in either the details description or the claims, such term is intended to be inclusive in a manner similar to the term "comprising" as "comprising" is interpreted when employed as a transitional word in a claim.

## Claims

1. A two-dimensional scanning radar system comprising:
a printed circuit board, PCB, (204) comprising:
a metal layer (200);
a substrate layer (202) that is adjacent the metal layer (200);
a slotted taper (212-216) etched into the metal layer (200); and
a substrate integrated waveguide, SIW, (206-210) in the substrate layer (202);
a plurality of monolithic microwave integrated circuits, MMICs, (402-406) that are mounted on the metal layer (200) of the PCB (204),
wherein the metal layer (200) includes solder balls to electrically couple the MMICs (402-406) to the PCB (204);
a plurality of transmitting, TX, antennas (104), wherein each MMIC (402-406) in the plurality of MMICs (402-406) is configured to drive at least one Tx antenna (104), wherein the MMIC (402-406) is electromagnetically coupled to a Tx antenna (104) by way of:
the slotted taper (212-216) of the PCB (204); and
the SIW (206-210) of the PCB (204) that is directly coupled to the tapered slot (212-216) such that an electromagnetic signal generated by the MMIC (402-406) passes directly from the MMIC (402-406) to the slotted taper (212-216) and directly from the slotted taper (212-216) to the SIW (206-210), wherein there is no microstrip line, MSL, transition to
electromagnetically couple the MMIC to the SIW.

2. The radar system of claim 1, further comprising a plurality of receiving, Rx, antennas (102), wherein each MMIC (402-406) in the plurality of MMICs (402-406) is configured to receive electromagnetic radiation detected by at least one Rx antenna (102), wherein the MMIC (402-406) is electromagnetically coupled to a Rx antenna (102) by way of:
a second SIW in the substrate layer (202) that is configured to receive the electromagnetic radiation detected in the environment by the Rx antenna (102); and
a second slotted taper etched into the metal layer (200) of the PCB (204) that is configured to receive the electromagnetic radiation from the second SIW, wherein the MMIC (402-406) is configured to receive the electromagnetic radiation from the second slotted taper.

3. The radar system of at least one of the preceding claims, wherein the plurality of Rx antennas (102) are electromagnetically coupled to the MMIC (402-406), and further wherein the Tx antenna (104) is the only transmit antenna that is electromagnetically coupled to the MMIC (402-406).

4. The radar system of at least one of the preceding claims, wherein the PCB (204) comprises:
a ground layer that is adjacent to the substrate layer (202); and
a pair of vias (218-220) that extend through the substrate layer (202) to the ground layer, wherein the pair of vias (218-220) is metallized, and further wherein the pair of metallized vias is configured to facilitate matching an impedance of the slotted taper (212-216) with an impedance of the SIW (206-210).

5. The radar system of claim 4, wherein the pair of metallized vias are further configured to cause out-of-band interfering signals to be filtered.

6. The radar system of at least one of claims 4-5, wherein the pair of vias (218-220) are located within the SIW (206-210).

7. The radar system of at least one of the preceding claims, further comprising a housing (106) that is thermally coupled to MMICs (402-406) by way of a thermally conductive material, wherein the housing (106) is configured to distribute heat evenly across the MMICs (402-406).

8. The radar system of at least one of the preceding claims, wherein the MMICs (402-406) are placed on a first side of the PCB (204), wherein the radar system further comprises a heat spreader (408) that is positioned on a second side of the PCB (204) that opposes the first side, wherein the PCB (204) has a cutout that extends therethrough, and further wherein the housing (106) is coupled to the heat spreader (408) by way of the cutout.

9. The radar system of claim 8, wherein the cutout is positioned between two MMICs (402-406) in the plurality of MMICs (402-406).

10. The radar system of at least one of the preceding claims, wherein the housing (106) is further configured to suppress electromagnetic radiation emitted by the MMICs (402-406) on the PCB (204).

11. A method comprising:
driving a transmitting, Tx, antenna (104) with an electromagnetic signal such that the Tx antenna (104) radiates the electromagnetic signal into an environment of a radar system, wherein driving the Tx antenna (104) with the electromagnetic signal comprises:
directing the electromagnetic signal over a path from a monolithic microwave integrated circuit, MMIC, (402-406) to the Tx antenna (104), wherein the path comprises:
a slotted taper (212-216) that is etched into a metal layer (200) of a printed circuit board, PCB (204), wherein the MMIC (402-406) is mounted on the PCB (204), wherein the metal layer (200) includes solder balls to electrically couple the MMICs (402-406) to the PCB (204), and further wherein the electromagnetic signal generated by the MMIC (402-406) passes directly from the MMIC (402-406) to the slotted taper (212-216) and directly from the slotted taper (212-216) to the SIW (206-210); and
a substrate integrated waveguide, SIW, (206-210) that is integrated into a substrate layer (202) of the PCB (204), wherein the substrate layer (202) is adjacent to the metal layer (200), and further wherein no microstrip line, MSL, transition is used to electromagnetically couple the MMIC to the SIW.

12. The method of claim 11, further comprising:
providing a reflection of the electromagnetic signal from a receiving, Rx, antenna (102) to the MMIC (402-406) over a second path, wherein the second path comprises:
a second SIW that is integrated into the substrate layer (202) of the PCB (204), wherein the reflection passes from the Rx antenna (102) to the second STW; and
a second tapered slot that is etched into the metal layer (200) of the PCB (204), wherein the reflection passes directly from the second SIW to the second tapered slot without an intervening microstrip line, and further wherein the electromagnetic signal passes from the second tapered slot to the MMIC (402-406).

13. The method of at least one of claims 11-12, further comprising:
dissipating heat emitted by the MMIC (402-406) by way of a metallic housing that is thermally coupled to the MMIC (402-406) by way of a thermally conductive material.

14. The method of at least one of claims 11 -13, wherein the housing includes a heat stamp (410, 412), and further wherein the heat is further dissipated by way of the heat stamp (410, 412) that extends through the substrate layer (202) of the PCB (204) to a heat spreader (408) that is positioned on a backside of the PCB (204).

15. The method of at least one of claims 11-14, wherein a metallized via extends from the substrate layer (202) of the PCB (204) to a ground layer that is adjacent the substrate layer (202) and opposite the metal layer (200), the method further comprising:
matching impedance of the tapered slot with impedance of the SIW (206-210) by way of the metallized via.

## Patentansprüche

1. Zweidimensionales Abtastradarsystem, umfassend:
eine Leiterplatte, PCB, (204), umfassend:
eine Metallschicht (200);
eine Substratschicht (202), die zu der Metallschicht (200) benachbart ist;
einen sich verjüngenden Schlitz (212-216), der in die Metallschicht (200) geätzt ist; und
einen substratintegrierten Wellenleiter, SIW, (206-210) in der
Substratschicht (202);
eine Vielzahl von monolithischen integrierten Mikrowellenschaltkreisen, MMICs, (402-406), die an der Metallschicht (200) der PCB (204) angebracht sind,
wobei die Metallschicht (200) Lötkugeln umfasst, um die MMICs (402-406) elektrisch mit der PCB (204) zu koppeln;
eine Vielzahl von Sende-, Tx-, Antennen (104), wobei jeder MMIC (402-406) der Vielzahl von MMICs (402-406) ausgestaltet ist, um zumindest eine Tx-Antenne (104) zu betreiben, wobei der MMIC (402-406) elektromagnetisch mit einer Tx-Antenne (104) gekoppelt ist durch:
den sich verjüngenden Schlitz (212-216) der PCB (204); und
den SIW (206-210) der PCB (204), der direkt mit dem sich verjüngenden Schlitz (212-216) gekoppelt ist, sodass ein elektromagnetisches Signal, das durch den MMIC (402-406) erzeugt wird, direkt von dem MMIC (402-406) zu dem sich verjüngenden Schlitz (212-216) und direkt von dem sich verjüngenden Schlitz (212-216) zu dem SIW (206-210) gelangt, wobei kein Mikrostreifenleitungs-, MSL-, Übergang vorgesehen ist, um den MMIC elektromagnetisch mit dem SIW zu koppeln.

2. Radarsystem nach Anspruch 1, ferner umfassend eine Vielzahl von Empfangs-, Rx-, Antennen (102), wobei jeder MMIC (402-406) der Vielzahl von MMICs (402-406) ausgestaltet ist, um elektromagnetische Strahlung zu empfangen, die durch zumindest eine Rx-Antenne (102) detektiert wird, wobei der MMIC (402-406) elektromagnetisch mit einer Rx-Antenne (102) gekoppelt ist durch:
einen zweiten SIW in der Substratschicht (202), der ausgestaltet ist, um die elektromagnetische Strahlung zu empfangen, die in der Umgebung durch die Rx-Antenne (102) detektiert wird; und
einen zweiten sich verjüngenden Schlitz, der in die Metallschicht (200) der PCB (204) geätzt ist und ausgestaltet ist, um die elektromagnetische Strahlung von dem zweiten SIW zu empfangen, wobei der MMIC (402-406) ausgestaltet ist, um die elektromagnetische Strahlung von dem zweiten sich verjüngenden Schlitz zu empfangen.

3. Radarsystem nach zumindest einem der vorstehenden Ansprüche, wobei die Vielzahl von Rx-Antennen (102) elektromagnetisch mit dem MMIC (402-406) gekoppelt ist, und wobei ferner die Tx-Antenne (104) die einzige Sendeantenne ist, die elektromagnetisch mit dem MMIC (402-406) gekoppelt ist.

4. Radarsystem nach zumindest einem der vorstehenden Ansprüche, wobei die PCB (204) umfasst:
eine Masseschicht, die zu der Substratschicht (202) benachbart ist; und
ein Paar von Durchkontaktierungen (218-220), die sich durch die Substratschicht (202) zu der Masseschicht erstrecken, wobei das Paar von Durchkontaktierungen (218-220) metallisiert ist, und wobei ferner das Paar von metallisierten Durchkontaktierungen ausgestaltet ist, um das Abgleichen einer Impedanz des sich verjüngenden Schlitzes (212-216) mit einer Impedanz des SIW (206-210) zu ermöglichen.

5. Radarsystem nach Anspruch 4, wobei das Paar von metallisierten Durchkontaktierungen ferner ausgestaltet ist um zu bewirken, dass außerbandige Störsignale gefiltert werden.

6. Radarsystem nach zumindest einem der Ansprüche 4-5, wobei das Paar von Durchkontaktierungen (218-220) innerhalb des SIW (206-210) angeordnet ist.

7. Radarsystem nach zumindest einem der vorstehenden Ansprüche, ferner umfassend ein Gehäuse (106), das thermisch mit den MMICs (402-406) mittels eines thermisch leitfähigen Materials gekoppelt ist, wobei das Gehäuse (106) ausgestaltet ist, um Wärme gleichmäßig über die MMICs (402-406) zu verteilen.

8. Radarsystem nach zumindest einem der vorstehenden Ansprüche, wobei die MMICs (402-406) auf einer ersten Seite der PCB (204) angeordnet sind, wobei das Radarsystem ferner einen Wärmeverteiler (408) umfasst, der auf einer zweiten Seite der PCB (204) positioniert ist, die der ersten Seite gegenüberliegt, wobei die PCB (204) einen Ausschnitt aufweist, der sich durch diese hindurch erstreckt, und wobei ferner das Gehäuse (106) mit dem Wärmeverteiler (408) mittels des Ausschnitts gekoppelt ist.

9. Radarsystem nach Anspruch 8, wobei der Ausschnitt zwischen zwei MMICs (402-406) der Vielzahl von MMICs (402-406) positioniert ist.

10. Radarsystem nach zumindest einem der vorstehenden Ansprüche, wobei das Gehäuse (106) ferner ausgestaltet ist, um elektromagnetische Strahlung zu unterdrücken, die durch die MMICs (402-406) an der PCB (204) emittiert wird.

11. Verfahren, umfassend:
Betreiben einer Sende-, Tx-, Antenne (104) mit einem elektromagnetischen Signal, sodass die Tx-Antenne (104) das elektromagnetische Signal in eine Umgebung eines Radarsystems ausstrahlt, wobei das Betreiben der Tx-Antenne (104) mit dem elektromagnetischen Signal umfasst:
Leiten des elektromagnetischen Signals über einen Pfad von einem monolithischen integrierten Mikrowellenschaltkreis, MMIC, (402-406) zu der Tx-Antenne (104), wobei der Pfad umfasst:
einen sich verjüngenden Schlitz (212-216), der in eine Metallschicht (200) einer Leiterplatte, PCB, (204) geätzt ist, wobei der MMIC (402-406) an der PCB (204) angebracht ist, wobei die Metallschicht (200) Lötkugeln umfasst, um die MMICs (402-406) elektrisch mit der PCB (204) zu koppeln, und wobei ferner das elektromagnetische Signal, das durch den MMIC (402-406) erzeugt wird, direkt von dem MMIC (402-406) zu dem sich verjüngenden Schlitz (212-216) und direkt von dem sich verjüngenden Schlitz (212-216) zu dem SIW (206-210) gelangt; und
einen substratintegrierten Wellenleiter, SIW, (206-210), der in eine Substratschicht (202) der PCB (204) integriert ist, wobei die Substratschicht (202) zu der Metallschicht (200) benachbart ist, und wobei ferner kein Mikrostreifenleitungs-, MSL-, Übergang verwendet wird, um den MMIC elektromagnetisch mit dem SIW zu koppeln.

12. Verfahren nach Anspruch 11, ferner umfassend:
Bereitstellen einer Reflexion des elektromagnetischen Signals von einer Empfangs-, Rx-, Antenne (102) für den MMIC (402-406) über einen zweiten Pfad, wobei der zweite Pfad umfasst:
einen zweiten SIW, der in die Substratschicht (202) der PCB (204) integriert ist, wobei die Reflexion von der Rx-Antenne (102) zu dem zweiten STW gelangt; und
einen zweiten sich verjüngenden Schlitz, der in die Metallschicht (200) der PCB (204) geätzt ist, wobei die Reflexion direkt von dem zweiten SIW zu dem zweiten sich verjüngenden Schlitz ohne eine dazwischenliegende Mikrostreifenleitung gelangt, und wobei ferner das elektromagnetische Signal von dem zweiten sich verjüngenden Schlitz zu dem MMIC (402-406) gelangt.

13. Verfahren nach zumindest einem der Ansprüche 11-12, ferner umfassend: Ableiten von Wärme, die durch den MMIC (402-406) emittiert wird, mittels eines metallischen Gehäuses, das mit dem MMIC (402-406) mittels eines thermisch leitfähigen Materials thermisch gekoppelt ist.

14. Verfahren nach zumindest einem der Ansprüche 11-13, wobei das Gehäuse einen Wärmestempel (410, 412) umfasst, und wobei ferner die Wärme ferner mittels des Wärmestempels (410, 412) abgeleitet wird, der sich durch die Substratschicht (202) der PCB (204) zu einem Wärmeverteiler (408) erstreckt, der auf einer Rückseite der PCB (204) positioniert ist.

15. Verfahren nach zumindest einem der Ansprüche 11-14, wobei sich eine metallisierte Durchkontaktierung von der Substratschicht (202) der PCB (204) zu einer Masseschicht erstreckt, die zu der Substratschicht (202) benachbart ist und der Metallschicht (200) gegenüberliegt, wobei das Verfahren ferner umfasst:
Abgleichen der Impedanz des sich verjüngenden Schlitzes mit der Impedanz des SIW (206-210) mittels der metallisierten Durchkontaktierung.

## Revendications

1. Système de radar à balayage bidimensionnel comprenant :
une carte à circuit imprimé, PCB, (204) comprenant :
une couche métallique (200) ;
une couche de substrat (202) adjacente à la couche métallique (200) ;
un cône à fentes (212-216) gravé dans la couche métallique (200) ;
et un guide d'ondes intégré au substrat, SIW, (206-210) dans la
couche de substrat (202) ;
une pluralité de circuits intégrés monolithiques hyperfréquences, MMIC, (402-406) montés sur la couche métallique (200) du PCB (204),
dans lequel la couche métallique (200) comprend des billes de soudure destinées à coupler électriquement les MMIC (402-406) au PCB (204) ;
une pluralit é d'antennes d'émission, Tx, (104), dans lesquelles chaque MMIC (402-406) de la pluralité de MMIC (402-406) est configuré pour piloter au moins une antenne Tx (104), le MMIC (402-406) étant couplé électromagnétiquement à une antenne Tx (104) via :
le cône à fentes (212-216) du PCB (204) ; et
le SIW (206-210) du PCB (204) qui est directement couplé au cône à fentes (212-216), de telle sorte qu'un signal électromagnétique généré par le MMIC (402-406) passe directement du MMIC (402-406) au cône à fentes (212-216) et directement du cône à fentes (212-216) au SIW (206-210), dans lequel aucune transition de ligne micro-ruban (MSL) n'est utilisée pour coupler électromagnétiquement le MMIC au SIW.

2. Système radar selon la revendication 1, comprenant en outre une pluralité d'antennes de réception, Rx, (102), dans lequel chaque MMIC (402-406) de la pluralité de MMIC (402-406) est configuré pour recevoir un rayonnement électromagnétique détecté par au moins une antenne Rx (102), dans lequel le MMIC (402-406) est couplé électromagnétiquement à une antenne Rx (102) via :
un deuxième SIW dans la couche de substrat (202) qui est configuré pour recevoir le rayonnement électromagnétique détecté dans l'environnement par l'antenne Rx (102) ; et
un deuxième cône à fentes gravé dans la couche métallique (200) du PCB (204), configuré pour recevoir le rayonnement électromagnétique provenant du deuxième SIW, le MMIC (402-406) étant configuré pour recevoir le rayonnement électromagnétique provenant du deuxième cône à fentes.

3. Système radar selon l'une au moins des revendications précédentes, dans lequel la pluralité d'antennes Rx (102) sont couplées électromagnétiquement au MMIC (402-406), et dans lequel, en outre, l'antenne Tx (104) est la seule antenne d'émission qui est couplée électromagnétiquement au MMIC (402-406).

4. Système radar selon l'une au moins des revendications précédentes, dans lequel le PCB (204) comprend :
une couche de masse adjacente à la couche de substrat (202) ; et
une paire de vias (218-220) qui s'étendent à travers la couche de substrat (202) jusqu'à la couche de masse, dans lequel la paire de vias (218-220) est métallisée, et en outre dans lequel la paire de vias métallisés est configurée pour faciliter l'adaptation de l'impédance du cône à fentes (212-216) à l'impédance du SIW (206-210).

5. Système radar selon la revendication 4, dans lequel la paire de vias métallisés est en outre configurée pour permettre le filtrage des signaux parasites hors bande.

6. Système radar selon l'une au moins des revendications 4 à 5, dans lequel la paire de vias (218-220) est située à l'intérieur du SIW (206-210).

7. Système radar selon l'une au moins des revendications précédentes, comprenant en outre un boîtier (106) qui est couplé thermiquement aux MMIC (402-406) au moyen d'un matériau thermoconducteur, dans lequel le boîtier (106) est configuré pour répartir la chaleur de manière uniforme sur les MMIC (402-406).

8. Système radar selon l'une au moins des revendications précédentes, dans lequel les MMIC (402-406) sont placés sur un premier côté du PCB (204), dans lequel le système radar comprend en outre un dissipateur thermique (408) positionné sur un deuxième côté du PCB (204) opposé au premier côté, le PCB (204) comportant une découpe qui le traverse, et dans lequel, en outre, le boîtier (106) est couplé au dissipateur thermique (408) par l'intermédiaire de la découpe.

9. Système radar selon la revendication 8, dans lequel la découpe est positionnée entre deux MMIC (402-406) parmi la pluralité de MMIC (402-406).

10. Système radar selon l'une au moins des revendications précédentes, dans lequel le boîtier (106) est en outre configuré pour supprimer le rayonnement électromagnétique émis par les MMIC (402-406) sur le PCB (204).

11. Procédé comprenant les étapes consistant à :
piloter une antenne d'émission, Tx, (104) avec un signal électromagnétique de telle sorte que l'antenne Tx (104) fait rayonner le signal électromagnétique dans l'environnement d'un système radar, le pilotage de l'antenne Tx (104) avec le signal électromagnétique comprenant de :
diriger le signal électromagnétique le long d'un trajet allant d'un circuit intégré monolithique hyperfréquence (MMIC) (402-406) vers l'antenne Tx (104), le trajet comprenant :
un cône à fentes (212-216) gravé dans une couche métallique (200) d'une carte de circuit imprimé, PCB (204), le MMIC (402-406) étant monté sur le PCB (204), la couche métallique (200) comprenant des billes de soudure destinées à coupler électriquement les MMIC (402-406) au PCB (204), et dans lequel, en outre, le signal électromagnétique généré par les MMIC (402-406) passe directement du MMIC (402-406) au cône à fentes (212-216) et directement du cône à fentes (212-216) au SIW (206-210) ; et
un guide d'ondes intégré au substrat, SIW, (206-210) qui est intégré dans une couche de substrat (202) du PCB (204), dans lequel la couche de substrat (202) est adjacente à la couche métallique (200), et dans lequel, en outre, aucune transition de ligne micro-ruban, MSL, n'est utilisée pour coupler électromagnétiquement le MMIC au SIW.

12. Procédé selon la revendication 11, comprenant en outre l'étape consistant à :
fournir une réflexion du signal électromagnétique provenant d'une antenne de réception, Rx, (102) au MMIC (402-406) le long d'un deuxième trajet, dans lequel le deuxième trajet comprend :
un deuxième SIW intégré dans la couche de substrat (202) du PCB (204), la réflexion passant de l'antenne Rx (102) au deuxième SIW ; et
un deuxième cône à fentes gravé dans la couche métallique (200) du PCB (204), la réflexion passant directement du deuxième SIW au deuxième cône à fentes sans ligne micro-ruban intermédiaire, et, en outre, le signal électromagnétique passant du deuxième cône à fentes au MMIC (402-406).

13. Procédé selon l'une au moins des revendications 11 à 12, comprenant en outre l'étape consistant à :
dissiper de la chaleur émise par le MMIC (402-406) au moyen d'un boîtier métallique qui est couplé thermiquement au MMIC (402-406) par l'intermédiaire d'un matériau thermoconducteur.

14. Procédé selon l'une au moins des revendications 11 à 13, dans lequel le boîtier comprend un tampon thermique (410, 412), et dans lequel, en outre, la chaleur est dissipée par l'intermédiaire du tampon thermique (410, 412) qui s'étend à travers la couche de substrat (202) du PCB (204) jusqu'à un dissipateur thermique (408) positionné sur la face arrière du PCB (204).

15. Procédé selon au moins l'une des revendications 11 à 14, dans lequel un via métallisé s'étend depuis la couche de substrat (202) du PCB (204) jusqu'à une couche de masse adjacente à la couche de substrat (202) et opposée à la couche métallique (200), le procédé comprenant en outre l'étape consistant à :
adapter l'impédance du cône à fentes à l'impédance du SIW (206-210) au moyen du via métallisé.
